# EUROPEAN PATENT SPECIFICATION

(11) **EP 3 211 672 B1**
(45) Date of publication and mention of the grant of the patent: **04.05.2022**
(21) Application number: 16160917.7
(22) Date of filing: 17.03.2016
(51) Int. Cl.: H01L 27/146

(54) **CHIP-SCALE PACKAGE FOR AN OPTICAL SENSOR SEMICONDUCTOR DEVICE WITH FILTER AND METHOD OF PRODUCING A CHIP-SCALE PACKAGE**
GEHÄUSE IN CHIP-GRÖSSE FÜR EIN HALBLEITERBAUELEMENT EINES OPTISCHEN SENSORS MIT FILTER UND VERFAHREN ZUR HERSTELLUNG EINES GEHÄUSES IN CHIP-GRÖSSE
BOÎTIER À MINIPUCE À CAPTEUR OPTIQUE POUR UN DISPOSITIF À SEMI-CONDUCTEUR AVEC FILTRE ET PROCÉDÉ DE PRODUCTION D'UN BOÎTIER-PUCE

(30) Priority: 24.02.2016 US 201662299106 P
(43) Date of publication of application: 30.08.2017
(73) Proprietor: ams AG, 8141 Premstätten (AT)
(72) Inventor: Marchl, Marco, 8142 Graz (AT); Dierschke, Eugene G., Dallas, TX 75248 (US)
(74) Representative: Epping - Hermann - Fischer

(56) References cited:
- US-A1- 2004 130 640
- US-A1- 2011 169 118

## Description

Production processes of optical sensor devices include applying a filter on a glass wafer, which is then bonded to a semiconductor wafer comprising the optical sensor. The filter is subject to stress, which is transferred to the glass wafer and may cause warpage. A minimum thickness of the glass wafer, which may be typically 300 µm, is required to prevent the risk of warpage and stress-related wafer breakage. The overall height of the packaged device is mainly due to the thickness of the glass wafer.

US 7,192,796 B2 discloses a packaged device including an integrated circuit die with a crystalline substrate having first and second generally planar surfaces and edge surfaces and semiconductor circuitry formed over the first planar surface, at least one chip scale packaging layer formed over the semiconductor circuitry and the first planar surface, and an insulation layer formed over the second planar surface and the edge surfaces. At least one electrical conductor is formed directly on the insulation layer overlying the second planar surface and is connected to the circuitry by at least one pad formed directly on the first planar surface.

US 2016/0020238 A1 discloses a semiconductor device for detection of radiation with a semiconductor substrate, a dielectric layer, an integrated circuit including at least one component sensitive to radiation, a wiring embedded in an intermetal layer of the dielectric layer, a through-substrate via contacting the wiring, and an optical filter element arranged immediately on the dielectric layer above the component sensitive to radiation. The dielectric layer comprises a dielectric passivation layer above the through-substrate via, the material of the passivation layer being different from the intermetal layer.

KR 20070103555 A discloses a wafer level chip scale package for an image sensor module including an image sensor with a light receiving part, a dummy substrate, an infrared filter glass, solder balls, and a printed circuit board. The substrate is adhered on an upper part of the image sensor and includes a window cavity formed on the substrate and a plurality of vias formed on the substrate around the cavity. The infrared filter glass is coupled to the substrate in order to uncover an area of the cavity. The solder balls are formed outside the IR filter glass on the substrate.

JP 4966902 B2 discloses a glass wafer incorporated in an optical filter for a wafer-level chip scale package. The optical filter is sandwiched between glass wafers of the same material quality and equal thickness to reduce the warpage of the cap wafer including the optical filter.

US 2011/0169118 A1 discloses an optical device comprising a semiconductor substrate, a light-receiving unit including light-receiving elements, microlenses and color filters disposed above the light-receiving unit, a light-transmissive plate, a bonding layer formed between the semiconductor substrate and the light-transmissive plate, an insulating film including an interlayer insulating film with a wiring and a passivation film, a planarizing film and electrodes serving as electrical connections to through electrodes.

US 2004/0130640 A1 discloses a solid-state imaging device comprising an imaging element wafer, wherein multiple solid-state imaging element chips have been formed on a silicon substrate. The imaging element wafer carries a photo-reception portion and electrode pads. An optical glass wafer is bonded onto the imaging element wafer by a bonding layer. The thickness of the optical glass wafer is in the order of several tens of µm up to several mm. A color filter may be formed of an organic material on the photo-reception portion.

It is an object of the present invention to disclose a chip-scale package of reduced size for an optical sensor semiconductor device including a filter, and to disclose an appertaining method of production.

These objects are achieved with the chip-scale package for an optical sensor semiconductor device according to claim 1 and with the method of producing a chip-scale package according to claim 8. Further embodiments and variants derive from the dependent claims.

The chip-scale package according to the present invention is disclosed in claim 1 and comprises a semiconductor substrate with a main surface, an optical sensor element integrated in the substrate at the main surface, a filter element arranged above the sensor element, and a glass wafer arranged above the main surface, so that the filter element is arranged between the main surface and the glass wafer. An intermediate layer is arranged between the filter element and the glass wafer, which is attached to the intermediate layer. The glass wafer has a thickness in the direction perpendicular to the main surface, and the package including the glass wafer has a further thickness in this direction, the thickness of the glass wafer being less than 200 µm. In particular, the thickness of the glass wafer may be less than 150 µm or even less than 100 µm.

The filter element can especially be an interference filter and may comprise more than one individual layer, in particular a sequence of several individual layers. The filter element is deposited on a semiconductor wafer, especially a silicon wafer, in order to reduce stress and allow the use of a thin glass wafer. Furthermore, the arrangement of the filter element on a semiconductor wafer allows to structure the filter element using standard semiconductor technology. If the thickness of the glass wafer is 100 µm or less and the thickness of the wafer including the intermediate layer is also 100 µm or less, the total package thickness without solder bumps will be smaller than 200 µm.

In an embodiment of the chip-scale package, the intermediate layer is a dielectric compound comprising the semiconductor material and may especially be a silicon oxide.

In a further embodiment of the chip-scale package, the intermediate layer is an adhesive layer comprising an organic material (glue layer).

At least one passivation layer is arranged between the main surface and the filter element.

At least one further passivation layer is arranged between the passivation layer and the intermediate layer, the further passivation layer being recessed above the sensor element. In particular, the further passivation layer may be a dielectric compound comprising the semiconductor material.

The method of producing a chip-scale package according to the invention is disclosed in claim 8 and comprises providing a semiconductor substrate with an optical sensor element integrated at a main surface of the substrate, arranging a filter element above the sensor element, applying an intermediate layer on or above the filter element, and attaching a bare glass wafer to the intermediate layer.

The thickness of the glass wafer in the direction perpendicular to the main surface is selected to be less than 200 µm. In particular, the thickness of the glass wafer may be selected to be less than 150 µm or even less than 100 µm. The intermediate layer may especially be formed from a dielectric compound comprising the semiconductor material, or it may be formed using an organic material or glue.

In the following, the invention is described in more detail in conjunction with the accompanying figures.
Figure 1 is a cross section of an example of the device which is not forming part of the claimed invention.
Figure 2 is a cross section of a further example with a different arrangement of the filter, wherein the further example is not forming part of the claimed invention.
Figure 3 is a cross section of an embodiment with a different structure of the intermediate layer.
Figure 4 is a cross section of components of an example not forming part of the claimed invention and illustrating the method.
Figure 5 is a cross section of an example not forming part of the claimed invention and comprising a through-substrate via.
Figure 6 is a cross section of a further example not forming part of the claimed invention and comprising a through-substrate via and a different arrangement of the filter.
Figure 7 is a cross section of a sensor region of an embodiment.
Figure 8 is a cross section according to Figure 7 after the formation of an opening above the sensor region.
Figure 9 is a cross section according to Figure 8 after the opening is filled with the filter element.
Figure 10 is a cross section according to Figure 8 after the opening is filled with a planarizing layer.
Figure 11 is a cross section according to Figure 10 after planarization.
Figure 12 is a cross section according to Figure 11 of an example not forming part of the claimed invention after the application of the filter element and the intermediate layer.
Figure 13 is a cross section according to Figure 11 after the application of the filter element and a further planarizing layer.
Figure 14 is a cross section according to Figure 13 after planarization.

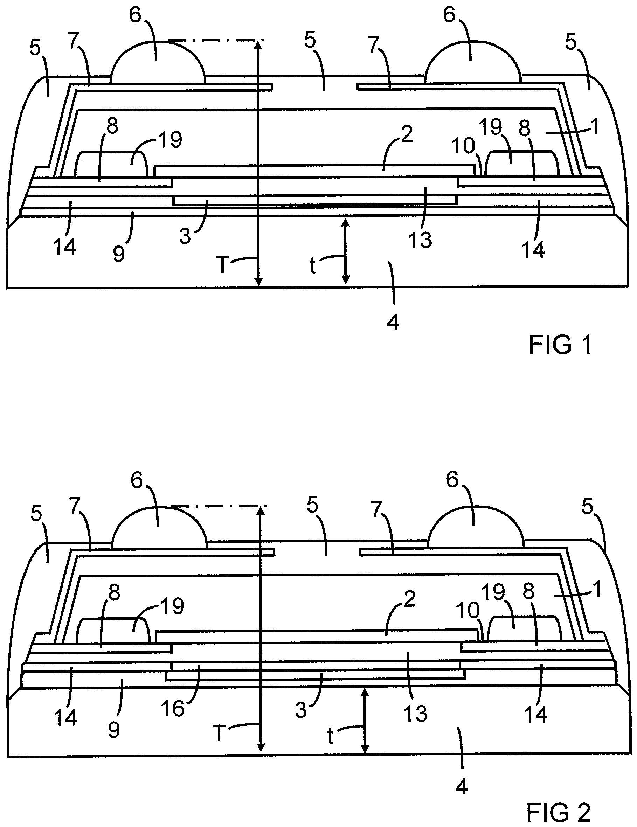

Figure 1 is a cross section of an example of the device which is not forming part of the claimed invention . It comprises a semiconductor substrate 1, an optical sensor element 2 integrated in the substrate 1 at a main surface 10, a filter element 3 above the sensor element 2, a glass wafer 4 and an intermediate layer 9.

The optical sensor element 2 is sensitive to electromagnetic radiation, which may include any range of the spectrum, like visible light or infrared radiation, for instance. The sensor element 2 may especially be a photodiode.

The filter layer 3 may comprise one filter layer or more than one filter layer and may especially be provided as an interference filter or an infrared filter, for instance. The filter element 3 is arranged between the sensor element 2 and the glass wafer 4, and the intermediate layer 9 is arranged between the filter element 3 and the glass wafer 4. The intermediate layer 9 may cover an entire area opposite the main surface 10, even if the filter element 3 is confined to an area opposite the sensor element 2.

The package may be encapsulated by an insulation 5 of a suitable dielectric material or a conventional molding compound, for instance. Bump contacts 6 for external electric connections may be arranged on metal pads 7 at the rear side opposite the main surface 10. In the example according to Figure 1, the metal pads 7 are drawn over edge surfaces of the substrate 1 and are connected to a wiring structure 8, which may provide electric connections to terminals of the sensor element 2 and to an integrated circuit 19, which may comprise CMOS components, for example. The wiring structure 8 may comprise multi-layer contacts, structured metal levels with interconnecting vias and intermetal dielectric, for example, which are known per se from semiconductor technology. Details of the wiring structure 8 are not relevant to the invention and are not shown in the figures.

A passivation layer 13 may be arranged between the sensor element 2 and the filter element 3. The passivation layer 13 may comprise an oxide of the semiconductor material, especially silicon oxide, for instance. The passivation layer 13 may comprise a sequence of individual layers, which may be formed from the same material or from different materials.

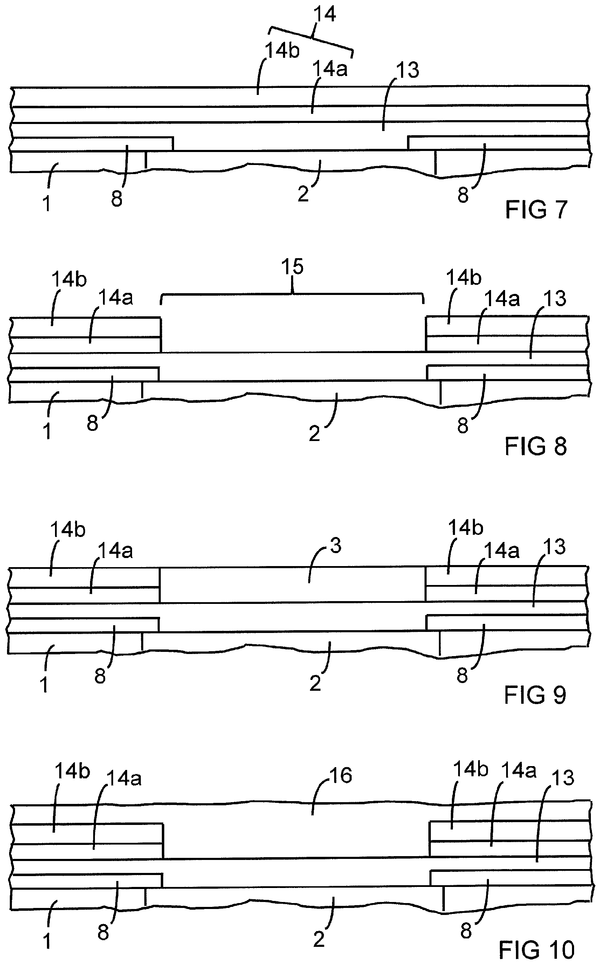

A further passivation layer 14 is arranged on the passivation layer 13. The further passivation layer 14 may comprise the same material as the passivation layer 13, or a different material. In particular, if the passivation layer 13 comprises an oxide of the semiconductor material, the further passivation layer 14 may comprise a nitride of the semiconductor material, especially silicon nitride, for instance. The further passivation layer 14 may comprise a sequence of individual layers, which may be formed from the same material or from different materials. Figures 7 to 14 show partial cross sections of an embodiment comprising a further passivation layer 14 formed by two partial layers.

If the material of the further passivation layer 14 is not sufficiently transparent or even opaque for the radiation that is to be detected by the sensor element 2, the further passivation layer 14 is recessed in the area above the sensor element 2, as shown in Figure 1 by way of example. In this case the filter element 3 may be arranged in the recess of the further passivation layer 14, so that the filter element 3 and the further passivation layer 14 are arranged on the same level above the main surface 10. A thin layer portion of the further passivation layer 14 may be left on the filter element 3, between the filter element 3 and the intermediate layer 9, as shown in Figure 1, to avoid any damage of the filter element 3 that might occur if the further passivation layer 14 is completely removed from the filter element 3.

The glass wafer 4 is directly attached to the intermediate layer 9, which is selected to be suitable for bonding. The intermediate layer 9 may be a dielectric compound comprising the same semiconductor material as the substrate and may especially be a silicon oxide, for instance. The intermediate layer 9 may instead be an adhesive layer comprising an organic material like a bonding glue, for instance, which is known per se in semiconductor technology.

The use of a glass wafer 4 that does not carry a filter layer reduces the risk of warpage. Consequently, it is thus possible to apply a bare glass wafer 4 that is substantially thinner than glass wafers that are conventionally used in a chip-scale package of an optical sensor semiconductor device.

The overall height of a conventional package that includes a glass wafer carrying a filter layer may be typically 540 µm, for instance, and the glass wafer may be typically about 300 µm thick. The use of a bare glass wafer 4 allows to reduce the required thickness of the glass wafer 4 to about 100 µm, so that the total thickness of the package becomes just about 340 µm, which is a substantial reduction.

The thickness t of the glass wafer 4 is indicated in Figure 1 by a double arrow pointing in the directions perpendicular to the main surface 10 of the substrate 1. The further thickness T of the entire package including the glass wafer 4 is similarly indicated by a double arrow pointing in the same directions. As the filter element 3 is not applied to the glass wafer 4, the thickness t may be less than 200 µm or even less than 100 µm without risk of warpage or wafer breaking.

In embodiments of the device, the thickness t may be less than 40% of the further thickness T. In particular, the thickness t of the glass wafer 4 may be less than 35% or even less than 30% of the further thickness T of the package. These relations may also apply to the further embodiments described below.

Figure 2 is a cross section of a further example which is not forming part of the claimed invention Elements of the example according to Figure 2 that correspond to elements of the example according to Figure 1 are designated with the same reference numerals. In the example according to Figure 2, the filter element 3 is arranged on a planarizing layer 16 filling a recess of the further passivation layer 14. The material of the planarizing layer 16 is selected to be at least essentially transparent for the radiation that is to be detected by the sensor element 2. The planarizing layer 16 may especially comprise the same material as the passivation layer 13.

In the example according to Figure 2, the filter element 3 is embedded in the intermediate layer 9. The filter element 3 and the intermediate layer 9 are arranged on the same level above the main surface 10. The intermediate layer 9 exceeds the filter element 3, because it is thicker than the filter element 3. Thus the intermediate layer 9 is also arranged between the filter element 3 and the glass wafer 4.

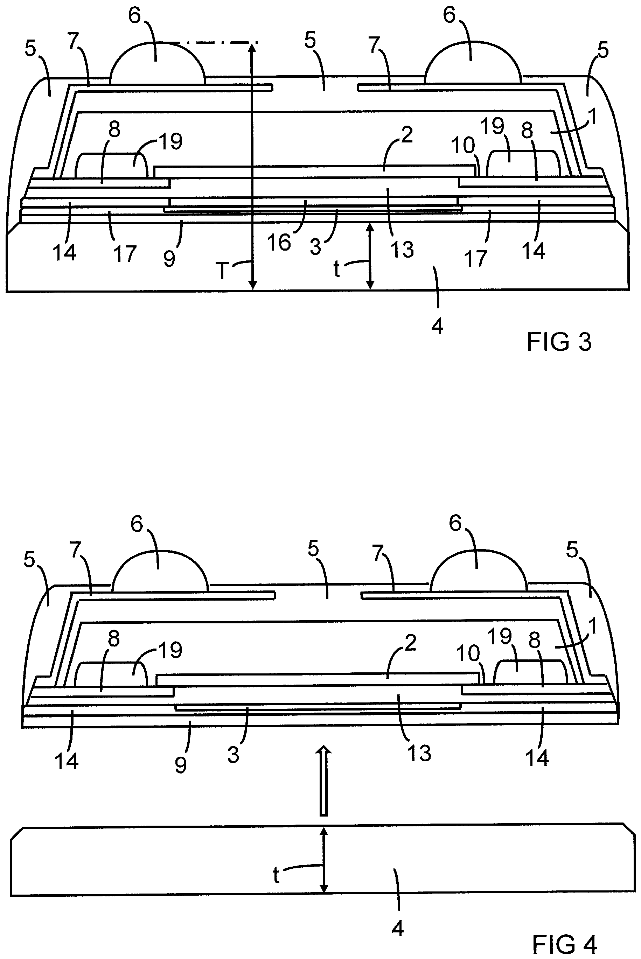

Figure 3 is a cross section of an embodiment. Elements of the embodiment according to Figure 3 that correspond to elements of the example according to Figure 2 are designated with the same reference numerals. In the embodiment according to Figure 3, a further planarizing layer 17 is arranged on the level of the filter element 3. A thin layer portion of the further planarization layer 17 is left on the filter element 3, between the filter element 3 and the intermediate layer 9, as shown in Figure 3, to avoid any damage of the filter element 3 that might occur if the further planarization layer 17 is completely removed from the filter element 3.

The further planarizing layer 17 may comprise the same material as the intermediate layer 9, for instance, or a different material. In particular, the further planarizing layer 17 may be a dielectric compound comprising the semiconductor material, and it may especially comprise the same material as the passivation layer 13 or the further passivation layer 14. The material of the intermediate layer 9 may differ from the material of the further planarizing layer 17 and may especially be an adhesive layer comprising an organic material, like a bonding glue, for instance. Figure 4 is a cross section of the substrate 1 provided with the filter element 3 and the intermediate layer 9 and a cross section of the bare glass wafer 4 before the glass wafer 4 is attached to the intermediate layer 9. Figure 4 does not form part of the claimed invention The method step of attaching the glass wafer 4 is indicated by the arrow pointing from the glass wafer 4 towards the intermediate layer 9.

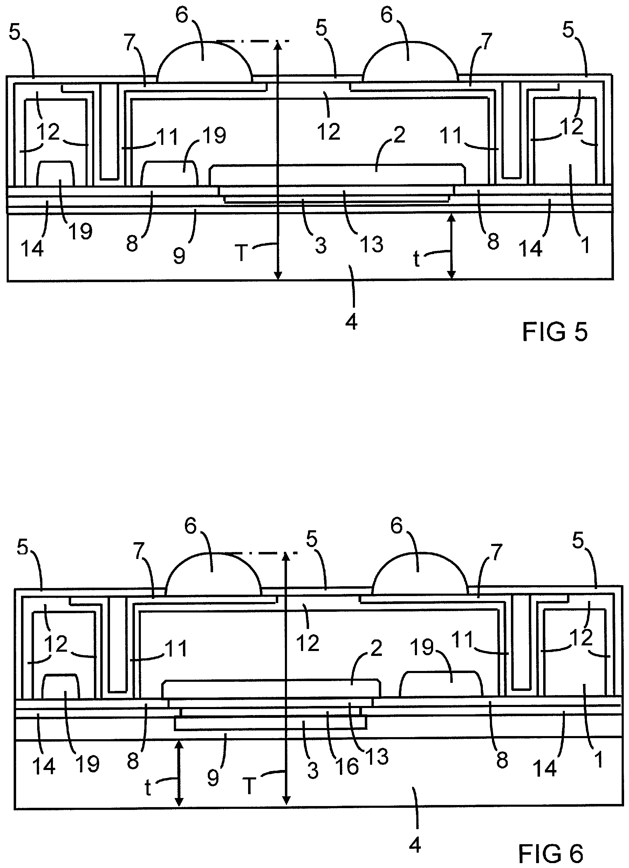

Figure 5 is a cross section of a further example not forming part of the claimed invention and comprising through-substrate vias. Elements of the example according to Figure 5 that correspond to elements of the example according to Figure 1 are designated with the same reference numerals. In the example according to Figure 5, the metal pads 7 are connected with the wiring structure 8 by the metallizations 11 of through-substrate vias. The metallizations 11 can be insulated from the substrate 1 by a dielectric layer 12, which may also be applied to the rear surface of the substrate 1, opposite the main surface 10, and to the edge surfaces, as shown in Figure 5 by way of example. There may be any number of through-substrate vias. It is also possible to connect at least one of the metal pads 7 with the wiring structure 8 by a conductor track running over an edge surface of the substrate 1 and at least another one of the metal pads 7 by a through-substrate via.

In Figure 5 the insulation 5 is represented as a thin covering layer, but it may instead be applied according to the example shown in Figure 1. The further passivation layer 14 may be recessed in the area above the sensor element 2. In particular, the filter element 3 may be arranged in the recess of the further passivation layer 14, as in the example according to Figure 1.

Figure 6 is a cross section of a further example not forming part of the claimed invention and comprising through-substrate vias. Elements of the example according to Figure 6 that correspond to elements of the example according to Figure 5 are designated with the same reference numerals. In the example according to Figure 6, the filter element 3 is arranged on a planarizing layer 16 filling the recess of the further passivation layer 14. The material of the planarizing layer 16 is selected to be at least essentially transparent for the radiation that is to be detected by the sensor element 2. The planarizing layer 16 may especially comprise the same material as the passivation layer 13, for instance.

Figure 7 is a cross section of the sensor region of an embodiment, which may be any of the examples according to Figures 1, 2 and 4 to 6 or the embodiment according to figure 3, and shows the sensor region before the application of the filter element 3. The sensor element 2 is integrated in the substrate 1. The wiring structure 8 is provided as an electric connection. The passivation layer 13, which may be silicon oxide, for instance, is applied and forms a planar surface.

In the embodiment shown in Figure 7, the further passivation layer 14 comprises two partial layers 14a, 14b. One partial layer 14a, which may be silicon nitride, for instance, is directly applied on the passivation layer 13. The material of the further partial layer 14b may be different from the material of the partial layer 14a, and may especially be the same as the material of the passivation layer 13, in particular silicon oxide, for instance.

If the further passivation layer 14 comprises a material that is not sufficiently transparent for the radiation that is to be detected, the further passivation layer 14 is recessed above the sensor element 2. This is shown in Figure 8, which is a cross section according to Figure 7 after the formation of an opening 15 in the passivation layer 14.

Figure 9 is a cross section according to Figure 8 after the opening 15 is filled. The filling can comprise the filter element 3. This example of the method which is no embodiment yields the examples according to Figures 1, 4 and 5. Instead, the filling can comprise a passivating material, in particular the same material as the passivation layer 13, for instance. In this case the filling forms a planarizing layer 16 of the passivation. The entire region of the passivation located above the sensor element 2 is thus made sufficiently transparent for the radiation that is to be detected.

Figure 10 is a cross section according to Figure 9 for the embodiment employing a planarizing layer 16, which fills the opening 15. The planarizing layer 16 may be applied exceeding the opening 15, as shown in Figure 10.

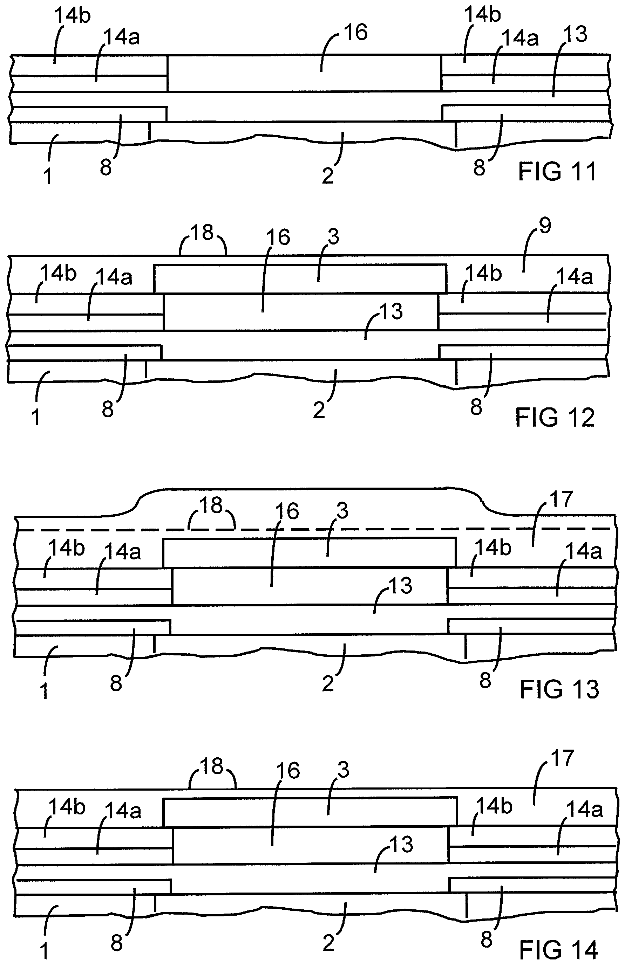

Figure 11 is a cross section according to Figure 10 after planarization. The planar surface thus obtained is formed by the surfaces of the further partial layer 14b of the further passivation layer 14 and the remaining portion of the planarization layer 16, which fills the opening 15.

Figure 12 is a cross section according to Figure 11 after the application of the filter element 3, which is arranged on the planar surface formed by the further partial layer 14b of the further passivation layer 14 and the planarizing layer 16. This arrangement of the filter element 3 yields the examples according to Figures 2 and 6 and the embodiment according to figure 3.

The intermediate layer 9 can be applied directly on the filter element 3. If the intermediate layer 9 is an organic material like a glue, which is sufficiently fluid to form a planar surface 18 without further treatment, the structure shown in Figure 12 is obtained. The bare glass wafer 4 can then be bonded by means of the adhesive intermediate layer 9.

A further planarizing layer 17 may instead be applied to obtain a planar surface 18 for the application of the intermediate layer 9. The filter element 3 and the further planarizing layer 17 may be applied in any order. If the further planarizing layer 17 is applied first, a recess is formed in the further planarizing layer 17, and the filter element 3 is arranged in the recess.

Figure 13 is a cross section according to Figure 12 for the embodiment wherein the filter element 3 is applied first. The further planarizing layer 17, which may be an oxide of the semiconductor material, for example, is applied directly on the filter element 3. The surface of the further planarizing layer 17 thus obtained may be at least approximately conformal to the surface on which the further planarizing layer 17 is applied. The further planarizing layer 17 is then partially removed to obtain a planar surface 18, the position of which is indicated in Figure 13 by a broken horizontal line.

Figure 14 is a cross section according to Figure 13 after the planarization. Figure 14 shows an embodiment. A thin layer portion of the further planarization layer 17 has been left on the filter element 3 to avoid any damage of the filter element 3 that might occur if the further planarization layer 17 is completely removed from above the filter element 3.

The arrangement of the filter on or above the substrate allows to attach a bare glass wafer. The risk of warpage is thus essentially reduced. Hence the glass wafer can be comparatively thin, and the total thickness of the package is substantially decreased. Furthermore, the glass wafer stabilizes the substrate, which can therefore be thinner than the substrate of a device without glass wafer.

Thus a total thickness of less than 500µm, and more desirable even less than 300pm, can be achieved for a package without bumps. High stress and wafer breakage are eliminated or at least substantially reduced by depositing the filter layer not on glass, but on the semiconductor wafer including CMOS components and the sensor element, prior to bonding the glass wafer. The bonding process is facilitated, because the intermediate layer can be used to provide a planar surface.

## Claims

1. A chip-scale package for an optical sensor semiconductor device, comprising:
- a semiconductor substrate (1) with a main surface (10),
- an optical sensor element (2) integrated in the substrate (1) at the main surface (10),
- a filter element (3) arranged above the sensor element (2), and
- a glass wafer (4) arranged above the main surface (10), so that the filter element (3) is arranged between the main surface (10) and the glass wafer (4), the thickness (t) of the glass wafer (4) in the direction perpendicular to the main surface (10) being less than 200 µm, wherein
- an intermediate layer (9) covering an entire area opposite the main surface (10) is arranged between the filter element (3) and the glass wafer (4), and
- the glass wafer (4) is directly attached to the intermediate layer (9), which is selected to be suitable for bonding, **characterized in that**
- a passivation layer (13) is arranged between the sensor element (2) and the filter element (3),
- a further passivation layer (14) is arranged on the passivation layer (13),
- the further passivation layer (14) is recessed in the area above the sensor element (2),
- the filter element (3) is arranged on a planarizing layer (16) filling a recess of the further passivation layer (14),
- a further planarizing layer (17) is arranged on the level of the filter element (3), and
- a thin layer portion of the further planarization layer (17) is left on the filter element (3), between the filter element (3) and the intermediate layer (9).

2. The chip-scale package according to claim 1, wherein the thickness (t) of the glass wafer (4) is less than 150 µm.

3. The chip-scale package according to claim 1, wherein the thickness (t) of the glass wafer (4) is less than 100 µm.

4. The chip-scale package according to one of claims 1 to 3, wherein
the intermediate layer (9) is a dielectric compound of the semiconductor material.

5. The chip-scale package according to one of claims 1 to 3, wherein
the intermediate layer (9) is a silicon oxide.

6. The chip-scale package according to one of claims 1 to 3, wherein
the intermediate layer (9) is an adhesive layer comprising an organic material or glue.

7. The chip-scale package according to claim 1, wherein the further passivation layer (14) is a dielectric compound of the semiconductor material.

8. A method of producing a chip-scale package, comprising:
- providing a semiconductor substrate (1) with an optical sensor element (2) integrated at a main surface (10) of the substrate (1), and
- arranging a filter element (3) above the sensor element (2), wherein
- an intermediate layer (9) is applied on or above the filter element (3), the intermediate layer (9) covering an entire area opposite the main surface (10),
- a bare glass wafer (4) is attached to the intermediate layer (9), and
- the thickness (t) of the glass wafer (4) in the direction perpendicular to the main surface (10) is less than 200 µm, **characterized in that**
- a passivation layer (13) is applied on the sensor element (2),
- a further passivation layer (14) is arranged on the passivation layer (13),
- an opening (15) is formed in the further passivation layer (14) above the sensor element (2),
- the opening is filled with a filling which comprises a passivating material and which forms a planarizing layer (16),
- a further planarizing layer (17) is applied directly on the filter element (3),
- the further planarizing layer (17) is then partially removed to obtain a planar surface (18),
- the further passivation layer (14) comprises a partial layer (14a) and a further partial layer (14b),
- the partial layer (14a) is directly applied on the passivation layer (13),
- the filter element (3) is arranged on the planar surface formed by the further partial layer (14b) of the further passivation layer (14) and the planarizing layer (16), and
- a thin layer portion of the further planarization layer (17) is left on the filter element (3), between the filter element (3) and the intermediate layer (9).

9. The method according to claim 8, wherein
the intermediate layer (9) is formed from a dielectric compound of the semiconductor material.

10. The method according to claim 8, wherein
the intermediate layer (9) is formed using an organic material or glue.

## Patentansprüche

1. Ein Gehäuse im Chip-Maßstab für ein optisches Sensor-Halbleiterelement, umfassend:
- ein Halbleitersubstrat (1) mit einer Hauptoberfläche (10),
- ein optisches Sensorelement (2), das in das Substrat (1) an der Hauptoberfläche (10) integriert ist,
- ein Filterelement (3), das oberhalb des Sensorelements (2) angeordnet ist, und
- einen über der Hauptoberfläche (10) angeordneten Glaswafer (4), so dass das Filterelement (3) zwischen der Hauptoberfläche (10) und dem Glaswafer (4) angeordnet ist, wobei die Dicke (t) des Glaswafers (4) in der Richtung senkrecht zur Hauptoberfläche (10) kleiner als 200 µm ist, wobei
- zwischen dem Filterelement (3) und dem Glaswafer (4) eine flächendeckende Zwischenschicht (9) gegenüber der Hauptoberfläche (10) angeordnet ist, und
- der Glaswafer (4) direkt an der Zwischenschicht (9) befestigt ist, die für eine Verbindung geeignet ausgewählt ist, **dadurch gekennzeichnet, dass**
- eine Passivierungsschicht (13) zwischen dem Sensorelement (2) und dem Filterelement (3) angeordnet ist,
- eine weitere Passivierungsschicht (14) auf der Passivierungsschicht (13) angeordnet ist,
- die weitere Passivierungsschicht (14) im Bereich oberhalb des Sensorelements (2) ausgenommen ist,
- das Filterelement (3) auf einer Planarisierungsschicht (16) angeordnet ist, die eine Ausnehmung der weiteren Passivierungsschicht (14) ausfüllt,
- auf der Ebene des Filterelements (3) eine weitere Planarisierungsschicht (17) angeordnet ist, und
- ein dünnschichtiger Teil der weiteren Planarisierungsschicht (17) auf dem Filterelement (3) zwischen dem Filterelement (3) und der Zwischenschicht (9) belassen wird.

2. Das Gehäuse im Chip-Maßstab gemäß Anspruch 1, wobei die Dicke (t) des Glaswafers (4) weniger als 150 µm beträgt.

3. Das Gehäuse im Chip-Maßstab gemäß Anspruch 1, wobei die Dicke (t) des Glaswafers (4) weniger als 100 µm beträgt.

4. Das Gehäuse im Chip-Maßstab gemäß einem der Ansprüche 1 bis 3, wobei
die Zwischenschicht (9) eine dielektrische Verbindung des Halbleitermaterials ist.

5. Das Gehäuse im Chip-Maßstab gemäß einem der Ansprüche 1 bis 3, wobei
die Zwischenschicht (9) ein Siliziumoxid ist.

6. Das Gehäuse im Chip-Maßstab gemäß einem der Ansprüche 1 bis 3, wobei
die Zwischenschicht (9) eine Klebstoffschicht ist, die ein organisches Material oder einen Klebstoff umfasst.

7. Das Gehäuse im Chip-Maßstab gemäß Anspruch 1, wobei die weitere Passivierungsschicht (14) eine dielektrische Verbindung des Halbleitermaterials ist.

8. Ein Verfahren zur Herstellung eines Gehäuses im Chip-Maßstab, umfassend:
- Bereitstellen eines Halbleitersubstrats (1) mit einem optischen Sensorelement (2), das auf einer Hauptoberfläche (10) des Substrats (1) integriert ist, und
- Anordnen eines Filterelements (3) oberhalb des Sensorelements (2), wobei
- eine Zwischenschicht (9) auf oder über dem Filterelement (3) aufgebracht ist, wobei die Zwischenschicht (9) einen gesamten Bereich gegenüber der Hauptoberfläche (10) bedeckt,
- auf der Zwischenschicht (9) ein blanker Glaswafer (4) angebracht ist, und
- die Dicke (t) des Glaswafers (4) in der Richtung senkrecht zur Hauptoberfläche (10) kleiner als 200 µm ist, **dadurch gekennzeichnet, dass**
- eine Passivierungsschicht (13) auf das Sensorelement (2) aufgebracht ist,
- eine weitere Passivierungsschicht (14) auf der Passivierungsschicht (13) angeordnet ist,
- in der weiteren Passivierungsschicht (14) oberhalb des Sensorelements (2) eine Öffnung (15) ausgebildet ist,
- die Öffnung mit einer ein passivierendes Material umfassenden Füllung gefüllt ist, die eine Planarisierungsschicht (16) ausbildet,
- eine weitere Planarisierungsschicht (17) direkt auf das Filterelement (3) aufgebracht wird,
- die weitere Planarisierungsschicht (17) dann teilweise entfernt wird, um eine ebene Oberfläche (18) zu erhalten,
- die weitere Passivierungsschicht (14) eine Teilschicht (14a) und eine weitere Teilschicht (14b) umfasst,
- die Teilschicht (14a) direkt auf die Passivierungsschicht (13) aufgebracht wird,
- das Filterelement (3) auf der von der weiteren Teilschicht (14b) der weiteren Passivierungsschicht (14) und der Planarisierungsschicht (16) ausgebildeten ebenen Fläche angeordnet ist, und
- zwischen dem Filterelement (3) und der Zwischenschicht (9) ein dünnschichtiger Teil der weiteren Planarisierungsschicht (17) auf dem Filterelement (3) belassen wird.

9. Das Verfahren gemäß Anspruch 8, wobei die Zwischenschicht (9) aus einer dielektrischen Verbindung des Halbleitermaterials ausgebildet wird.

10. Das Verfahren gemäß Anspruch 8, wobei die Zwischenschicht (9) unter Verwendung eines organischen Materials oder Klebstoffs ausgebildet wird.

## Revendications

1. Un package à l'échelle de la puce pour un dispositif semi-conducteur de capteur optique, comprenant :
- un substrat semi-conducteur (1) avec une surface principale (10),
- un élément capteur optique (2) intégré dans le substrat (1) au niveau de la surface principale (10),
- un élément de filtre (3) disposé au-dessus de l'élément capteur (2), et
- une galette de verre (4) disposée au-dessus de la surface principale (10), de sorte que l'élément de filtre (3) est disposé entre la surface principale (10) et la galette de verre (4), l'épaisseur (t) de la galette de verre (4) dans la direction perpendiculaire à la surface principale (10) étant inférieure à 200 µm, dans lequel
- une couche intermédiaire (9) couvrant toute une zone opposée à la surface principale (10) est disposée entre l'élément filtrant (3) et la galette de verre (4), et
- la galette de verre (4) est directement fixée à la couche intermédiaire (9), qui est choisie pour être adaptée au collage, **caractérisé en ce que**
- une couche de passivation (13) est disposée entre l'élément capteur (2) et l'élément filtrant (3),
- une couche de passivation supplémentaire (14) est disposée sur la couche de passivation (13),
- la couche de passivation supplémentaire (14) est évidée dans la zone située au-dessus de l'élément capteur (2),
- l'élément de filtre (3) est disposé sur une couche de planarisation (16) remplissant un évidement de la couche de passivation supplémentaire (14),
- une couche de planarisation supplémentaire (17) est disposée au niveau de l'élément de filtre (3), et
- une partie de couche mince de la couche de planarisation supplémentaire (17) est laissée sur l'élément de filtre (3), entre l'élément de filtre (3) et la couche intermédiaire (9).

2. Le package à l'échelle de la puce selon la revendication 1, dans lequel
l'épaisseur (t) de la galette de verre (4) est inférieure à 150 µm.

3. Le package à l'échelle de la puce selon la revendication 1, dans lequel
l'épaisseur (t) de la galette de verre (4) est inférieure à 100 µm.

4. Le package à l'échelle de la puce selon l'une des revendications 1 à 3, dans lequel
la couche intermédiaire (9) est un composé diélectrique du matériau semi-conducteur.

5. Le package à l'échelle de la puce selon l'une des revendications 1 à 3, dans lequel
la couche intermédiaire (9) est un oxyde de silicium.

6. Le package à l'échelle de la puce selon l'une des revendications 1 à 3, dans lequel
la couche intermédiaire (9) est une couche adhésive comprenant un matériau organique ou une colle.

7. Le package à l'échelle de la puce selon la revendication 1, dans lequel
la couche de passivation supplémentaire (14) est un composé diélectrique du matériau semi-conducteur.

8. Une procédure de production d'un package à l'échelle de la puce, comprenant :
- la fourniture d'un substrat semi-conducteur (1) avec un élément de capteur optique (2) intégré à une surface principale (10) du substrat (1), et
- le dispositif d'un élément de filtre (3) au-dessus de l'élément capteur (2), dans lequel
- une couche intermédiaire (9) est appliquée sur ou au-dessus de l'élément de filtre (3), la couche intermédiaire (9) couvrant une zone entière opposée à la surface principale (10),
- une galette de verre nue (4) est fixée à la couche intermédiaire (9), et
- l'épaisseur (t) de la galette de verre (4) dans la direction perpendiculaire à la surface principale (10) est inférieure à 200 µm, **caractérisé en ce que**
- une couche de passivation (13) est appliquée sur l'élément capteur (2),
- une couche de passivation supplémentaire (14) est disposée sur la couche de passivation (13),
- une ouverture (15) est formée dans la couche de passivation supplémentaire (14) au-dessus de l'élément capteur (2),
- l'ouverture est remplie d'un remplissage qui comprend un matériau de passivation et qui forme une couche de planarisation (16),
- une couche de planarisation supplémentaire (17) est appliquée directement sur l'élément de filtre (3),
- la couche de planarisation supplémentaire (17) est ensuite partiellement retirée pour obtenir une surface plane (18),
- la couche de passivation supplémentaire (14) comprend une couche partielle (14a) et une couche partielle supplémentaire (14b),
- la couche partielle (14a) est appliquée directement sur la couche de passivation (13),
- l'élément filtrant (3) est disposé sur la surface plane formée par la couche partielle supplémentaire (14b) de la couche de passivation supplémentaire (14) et la couche de planarisation (16), et
- une partie de couche mince de la couche de planarisation supplémentaire (17) est laissée sur l'élément de filtre (3), entre l'élément de filtre (3) et la couche intermédiaire (9).

9. La procédure selon la revendication 8, dans lequel la couche intermédiaire (9) est formée d'un composé diélectrique du matériau semi-conducteur.

10. La procédure selon la revendication 8, dans lequel la couche intermédiaire (9) est formée en utilisant un matériau organique ou une colle.
